# EUROPÄISCHE PATENTSCHRIFT

(11) **EP 3 766 317 B1**
(45) Veröffentlichungstag und Bekanntmachung des Hinweises auf die Patenterteilung: **16.03.2022**
(21) Anmeldenummer: 19725063.2
(22) Anmeldetag: 13.05.2019
(51) Int. Cl.: H05K 7/20

(54) **GERÄTESCHRANK UND VERFAHREN ZUM BETREIBEN EINER KÜHLEINRICHTUNG**
EQUIPMENT CABINET AND METHOD FOR OPERATING A COOLING DEVICE
ARMOIRE POUR APPAREILS ET PROCÉDÉ DE FONCTIONNEMENT D'UN DISPOSITIF DE REFROIDISSEMENT

(30) Priorität: 11.06.2018 DE 102018113806
(43) Veröffentlichungstag der Anmeldung: 20.01.2021
(73) Patentinhaber: Vertiv S.r.l., 35028 Piove di Sacco, (PD) (IT)
(72) Erfinder: EBERMANN, Heiko, 01109 Dresden (DE); KOCH, Peter, 86946 Vilgertshofen (DE)
(74) Vertreter: Wunderlich & Heim Patentanwälte Partnerschaftsgesellschaft mbB
(86) Internationale Anmeldenummer: PCT/EP2019/062183
(87) Internationale Veröffentlichungsnummer: WO 2019/238326

(56) Entgegenhaltungen:
- EP-A2- 2 456 293
- WO-A1-2009/156649
- WO-A2-2007/019304
- US-A1- 2015 003 010

## Beschreibung

Die Erfindung betrifft einen Geräteschrank zur Aufnahme von Komponenten der Informations- und Kommunikationstechnik, welche im Betrieb Abwärme erzeugen. Dieser Geräteschrank weist eine Front- und eine Rückseite auf. Der Geräteschrank und/oder die Komponenten der Informations- und Kommunikationstechnik sind ausgebildet, Kühlluft von der Frontseite des Geräteschrankes zum Kühlen zu nutzen und in Richtung der Rückseite als erwärmte Abluft, welche des Weiteren als Warmluft bezeichnet wird, abzugeben. Zum Kühlen der Warmluft ist eine Kühleinrichtung vorgesehen, welche die Warmluft kühlt und an eine Umgebung des Geräteschrankes abgibt, wobei die Kühleinrichtung Lüfter zum Ansaugen der Warmluft und zum Ausblasen der gekühlten Warmluft aufweist. Die Komponenten der Informations- und Kommunikationstechnik, welche in dem Geräteschrank vorgesehen sind, bilden an deren Rückseite einen Warmluftbereich mit Warmluft aus.

Ferner betrifft die Erfindung ein Verfahren zum Betreiben einer Kühleinrichtung, insbesondere der Lüfter einer Kühleinrichtung, für einen Geräteschrank zur Aufnahme von Komponenten der Informations- und Kommunikationstechnik, welche im Betrieb Abwärme erzeugen. Hierbei weist der Geräteschrank eine Front- und Rückseite auf, wobei der Geräteschrank und/oder die Komponenten der Informations- und Kommunikationstechnik ausgebildet sind, Kühlluft von der Frontseite zum Kühlen zu nutzen und in Richtung der Rückseite als erwärmte Abluft, welche des Weiteren als Warmluft bezeichnet wird, abzugeben. Hierbei ist zum Kühlen der Warmluft die Kühleinrichtung vorgesehen, welche die Warmluft kühlt und an eine Umgebung des Geräteschrankes ausgibt. Die Kühleinrichtung weist Lüfter zum Ansaugen der Warmluft und zum Ausblasen der gekühlten Warmluft auf.

Im Sinne der Erfindung können unter Komponenten der Informations- und Kommunikationstechnik beispielsweise Telekommunikationsgeräte, Switches, Netzwerkkomponenten aber auch USVs verstanden werden.

Gattungsgemäße Geräteschränke, welche auch als Serverschränke bezeichnet werden, werden zur Aufnahme von Komponenten der Informations- und Kommunikations-technik wie beispielsweise Servern verwendet. Diese Server erzeugen während ihres Betriebes Abwärme, welche aus dem Geräteschrank abgeführt werden muss. Hierbei ist es Stand der Technik, dass von der Frontseite des Geräteschrankes kühle Luft einströmt beziehungsweise eingesaugt wird, über die Abwärme produzierenden Komponenten der Server strömt und die so erwärmte Luft, die im Folgenden als Warmluft bezeichnet wird, in Richtung der Rückseite des Geräteschrankes ausgegeben wird. Um die Warmluft nicht in die Umgebung des Geräteschrankes abzugeben ist es oft vorgesehen, in der Umfassungskonstruktion des Geräteschrankes Kühleinrichtung, das heißt Wärmetauscher, vorzusehen, welche die Warmluft kühlen und die gekühlte Warmluft dann an die Umgebung abgeben.

Der hierfür notwendige Luftstrom von der Frontseite des Geräteschrankes zur Rückseite des Geräteschrankes wird durch Lüfter erreicht, welche teilweise an oder in den Servern vorhanden sind und die Luft aktiv in den Schrank hineinsaugen und an der Rückseite der Server wieder abgeben. Ebenso ist es vorgesehen, das alternativ oder zusätzlich hierzu auch an den Kühleinrichtungen Lüfter vorgesehen sind, die wiederum die Luft durch die Server saugen, so dass kalte Luft in die Server hineingesaugt wird, an der Rückseite der Server wieder abgesaugt wird und in die Kühleinrichtung eingesaugt wird. Die Lüfter dienen auch dazu, die gekühlte Warmluft aus der Kühleinrichtung wieder hinaus in die Umgebung zu blasen.

Die Verwendung von Lüftern in Verbindung mit einer Kühleinrichtung ist insbesondere dann sinnvoll beziehungsweise notwendig, wenn in dem Geräteschrank auch passive Komponenten der Informations- und Kommunikationstechnik vorgesehen sind. Dies in bedeutet, dass diese Komponenten keine aktiven Luftführungs- beziehungsweise Luftbewegungsmittel aufweisen. Dann ist es erforderlich, dass durch andere Mittel, wie beispielsweise die Lüfter in der Kühleinrichtung, aktiv Luft über diese passiven Komponenten der Informations- und Kommunikationstechnik gesogen wird. Beispielsweise kann es sich hierbei um eine USV handeln, die selbst keine aktiven Lüfter aufweist aber entsprechende Lüftungskanäle.

Eine Anforderung ist eine möglichst optimale Kühlung der Komponenten der Informations- und Kommunikationstechnik ohne hierzu zu viel Energie aufzuwenden. Dies bedeutet, dass die Kühltemperatur der gekühlten Warmluft aber auch der Luftstrom, das heißt der Volumenstrom pro Zeiteinheit, eingestellt werden kann. Dies wird in Geräteschränken mit einer rückwärtig angeordneten Kühleinrichtung derzeit oft mittels Temperatursensoren ausgeführt, welche die Austrittstemperatur der gekühlten Warmluft messen. Wenn die Austrittstemperatur der gekühlten Warmluft beispielsweise über einem Schwellwert liegt, wird entweder eine höhere Kühlleistung veranlassen oder die Lüfter in den Kühleinrichtungen schneller laufen lassen, damit ein größerer Volumenstrom durch die Komponenten der Informations- und Kommunikationstechnik gezogen wird, so dass die in die Kühleinrichtung eintretende Luft bereits kühler ist.

Aus der WO 2007/019304 A1, der US 2015/0003010 A1, der WO 2019/156649 A1 und der EP 2 456 293 A1 sind verschiedene Verfahren zum Regeln der Kühlung von Serverschränken bekannt. Hierbei werden aktive Lüfter verwendet, wobei zum Teil auch der Druck innerhalb des Schranks berücksichtigt wird.

Der Erfindung liegt die **Aufgabe** zugrunde, einen Geräteschrank zu schaffen sowie ein Verfahren zum Regeln einer Kühleinrichtung anzugeben, mit dem eine effektive Kühlung von Komponenten in einem Geräteschrank ermöglicht.

Diese Aufgabe wird durch einen Geräteschrank mit den Merkmalen des Anspruchs 1 und durch ein Verfahren zum Betreiben einer Kühleinrichtung mit den Merkmalen des Anspruchs 6 gelöst.

Bevorzugte Ausführungsformen der Erfindung sind in den abhängigen Ansprüchen und in der Beschreibung angegeben.

Ein gattungsgemäßer Geräteschrank ist erfindungsgemäß dadurch weitergebildet, dass Sensoren zum Ermitteln der Druckdifferenz zwischen dem Warmluftbereich und dem Abgabebereich der gekühlten Warmluft der Kühleinrichtung an die Umgebung vorgesehen sind und dass die Kühleinrichtung ausgebildet und eingerichtet ist mittels der Lüfter einen festgelegten Druck im Warmluftbereich aufrechtzuerhalten, wobei der Druck kleiner oder gleich dem Druck in der Umgebung des Geräteschrankes ist.

Ein Grundgedanke der Erfindung kann darin gesehen werden, von einer Regelung der Kühleinrichtung, insbesondere deren Lüftern, allein an Hand von gemessenen Temperaturen abzuweichen. Der Erfindung liegt die Erkenntnis zugrunde, dass es wesentlich für den Luftstrom über die Komponenten der Informations- und Kommunikationstechnik ist, welcher zur Kühlung eingesetzt wird, wie die Druckverhältnisse im Warmluftbereich sind, welcher auch als Warmluftplenum bezeichnet werden kann.

Herrscht hier Überdruck, das heißt wird mehr Luft über die Komponenten der Informations- und Kommunikationstechnik durch die vorhandenen Lüfter gesogen, beziehungsweise geblasen als durch die Kühleinrichtung wieder ausgestossen werden kann, müssen die vorhandenen Lüfter an den Komponenten der Informations- und Kommunikationstechnik mehr Leistung liefern als notwendig, was zu einem erhöhten Lüfterverschleiß führt.

Ebenfalls kann es bei Überdruck zu Rückströmungen der Warmluft aus dem Warmluftplenum nach vorne an die Frontseite des Geräteschrankes zum Einsaugbereich beziehungsweise Einströmbereich der Kühlluft kommen. Dies wirkt sich negativ auf die Kühlmöglichkeit der gesamten Komponenten im Geräteschrank aus.

Ebenso kann es nachteilig sein, wenn ein großer Unterdruck im Warmluftplenum vorhanden ist. Dies bedeutete, dass die Lüfter der Kühleinrichtung mehr Luft transportieren, also aus dem Warmluftplenum absaugen, als über die Komponenten der Informations- und Kommunikationstechnik beziehungsweise deren Lüfter in das Warmluftplenum einfließt. Neben dem erhöhten Energieverbrauch der Lüfter der Kühleinrichtung wird hierbei ebenfalls das Risiko erhöht, Falschluft anzusaugen, das heißt Luft von außerhalb des Geräteschrankes anzusaugen, die nicht über die Komponenten der Informations- und Kommunikationstechnik geführt wurde und zu deren Kühlung eingesetzt wurde.

Daher ist es entsprechend der Erfindung vorgesehen, die Druckdifferenz zwischen dem Warmluftbereich und der Umgebung als eine Richtgröße zu verwenden. Idealerweise sollte hierbei der Druck, insbesondere der statische Druck, einmal im Warmluftbereich und einmal an der Frontseite des Geräteschrankes ermittelt und ausgewertet werden. Da die Druckdifferenz jedoch zur Regelung der Kühleinrichtung verwendet werden soll und die entsprechenden Regelmittel auch in dieser vorgesehen sind, ist es äußerst unpraktisch, wenn entsprechende Leitungen von der Kühleinrichtung, welche sich oft an der Rückseite eines Geräteschrankes befindet, durch den Geräteschrank auf die Frontseite verlegt werden müssten. Daher liegt der Erfindung eine weitere Erkenntnis zugrunde und zwar, dass der Druck am Ausgabebereich der gekühlten Warmluft der Kühleinrichtung im Wesentlichen dem Druck entspricht, der vor dem Geräteschrank an dessen Frontseite vorhanden ist. Somit kann, mit relativ kurzen Leitungen zum einen der statische Druck an der Rückseite des Geräteschrankes, das heißt am Abgabebereich der gekühlten Warmluft der Kühleinrichtung und zum anderen im Warmluftbereich ermittelt werden. Über diese zwei Druckwerte kann eine Druckdifferenz berechnet werden und die Kühleinrichtung, insbesondere deren Lüfter, derart gesteuert werden, dass der Druck im Warmluftbereich gleich dem Umgebungsdruck des Geräteschrankes oder lediglich etwas geringer als dieser ist.

In einer bevorzugten Ausführungsform ist die Kühleinrichtung als Rücktür-Kühleinrichtung ausgeführt, welche an der hintern Wand oder Tür des Geräteschrankes oder anstelle der Rücktür des Geräteschrankes vorgesehen ist.

Eine derartige Ausführung ermöglicht zum einen eine leichte Anbringung der Kühleinrichtung. Zum anderen wird somit ermöglicht ohne zusätzliche Umlenkungen die zum Kühlen verwendete Luft von vorne in den Geräteschrank einzusaugen, über die Komponenten der Informations- und Kommunikationstechnik zu führen, in den Warmluftbereich abzugeben und aus dem Warmluftbereich über die Kühleinrichtung in Form eines Rücktürkühlers zu kühlen und nach hinten wiederum abzuführen.

Vorteilhaft ist es, wenn mindestens ein Sensor zum Ermitteln des Druckes im Warmluftbereich im oder am Rahmen des Geräteschrankes, insbesondere in einer Nut vorgesehen ist. Der durch die Sensoren zum Ermittelten des Druckes festgestellte Druck sollte bevorzugt ein statischer Druck und kein dynamischer Druck sein. Statisch bedeutet, dass es sich hierbei um den Druck ohne Umgebungseinflüsse, insbesondere Luftströmungen, handelt. Im Warmluftbereich sind jedoch konstruktionsbedingt hohe Luftströmungen vorhanden, da dort die Luft durch die Komponenten der Informations- und Kommunikationstechnik hineingeblasen und anschließend durch die Kühleinrichtung herausgesaugt wird. Daher hat es sich entsprechend der Erfindung als vorteilhaft herausgestellt, wenn die Sensoren zum Ermitteln des Druckes geschützt angebracht sind. Hierbei kann insbesondere eine Nut in einem Rahmengestell des Geräteschrankes verwendet werden. Derartige Nuten sind standardmäßig zur Befestigung von Bauteilen vorhanden, so dass sie nicht zusätzlich vorgesehen werden müssen und erfahrungsgemäß groß genug um derartige Sensoren aufzunehmen. Eine entsprechende Messstelle hat sich als relativ wenig durch die Luftströmung im Warmluftbereich beeinflussbar herausgestellt.

Erfindungsgemäss ist weiterhin vorgesehen, dass mindestens ein Temperatursensor an mindestens einer der folgenden Stellen vorgesehen sind: außerhalb des Geräteschrankes, an der Frontseite des Geräteschrankes, im Warmluftbereich, am Abgabebereich der Kühleinrichtung, vor, hinter, innerhalb der Komponenten der Informations- und Kommunikationstechnik, wobei die Kühleinrichtung ausgebildet und eingerichtet ist, anhand der durch den mindestens einen Temperatursensor festgestellten Temperatur, den Druck im Warmluftbereich zu regeln, und/oder, dass die Kühleinrichtung ausgebildet und eingerichtet ist anhand der momentanen Leistungsaufnahme der Komponenten der Informations- und Kommunikationstechnik den Druck im Warmluftbereich zu regeln, und/ oder dass die Kühleinrichtung ausgebildet und eingerichtet ist, anhand von Daten aus einem Servermanagement, insbesondere CPU-Leistungen, Rechnerauslastung und/oder Netzwerkauslastungen den Druck im Warmluftbereich zu regeln.

Wie erwähnt kann im Bereich des Geräteschrankes mindestens ein Temperatursensor an mindestens einer der folgenden Stellen vorgesehen sein: außerhalb des Geräteschrankes, an der Frontseite des Geräteschrankes, im Warmluftbereich, im Abgabebereich der Kühleinrichtung, vor, hinter, innerhalb der Komponenten der Informations- und Kommunikationstechnik. Diesbezüglich kann die Kühleinrichtung ausgebildet und eigerichtet sein, anhand der zusätzlich durch den mindestens einen Temperatursensor festgestellten Temperatur den Druck im Warmbereich ebenfalls zu regeln. Eine derartige Regelung kann als dynamische Druckregelung angesehen werden bei der nicht mehr ein festgelegter Druck im Warmbereich durch die Lüfter der Kühleinrichtung aufrechterhalten wird, sondern basierend auf dem Messergebnis des oder der Temperatursensoren dieser Druck angepasst wird.

Beispielsweise kann, wenn festgestellt wird, dass ein Temperatursensor der innerhalb der Komponenten der Informations- und Kommunikationstechnik oder an ihnen vorgesehen ist, eine höhere Temperatur anzeigt als gewünscht, im Warmluftbereich der statische Druck verringert werden, indem die Lüfter der Kühleinrichtung mit einer höheren Geschwindigkeit betrieben werden. Dies hat zur Folge, dass der Luftstrom über die Komponenten der Informations- und Kommunikationstechnik erhöht wird und diese somit besser gekühlt werden. In ähnlicher Weise kann, wenn im Warmluftbereich eine sehr hohe Temperatur gemessen wird, ebenfalls der Unterdruck im Warmluftbereich erhöht werden. Anders herum ist es beispielsweise auch möglich, wenn im Abgabebereich der Kühleinrichtung eine sehr kühle Temperatur festgestellt wird, die unterhalb eines Sollwertes liegt, die Lüfter mit einer geringeren Drehzahl zu betreiben und somit den Druck im Warmluftbereich zu verringern, so dass insgesamt weniger Luft gefördert wird, was wiederum zur Folge hat, dass weniger Kühlleistung angeboten wird. Alternativ und zusätzlich hierzu können Einrichtungen vorgesehen sein, um die gesamte oder zumindest einen Großteil der Leistungsaufnahme der Komponenten der Informations- und Kommunikationstechnik festzustellen und die Kühleinrichtung kann entsprechend ausgebildet und eingerichtet sein, anhand der festgestellten Leistungsaufnahme den Druck im Warmbereich zu regeln. Hierbei ist es beispielsweise möglich, die gesamte Stromaufnahme der im Geräteschrank vorhandenen Komponenten der Informations- und Kommunikationstechnik anhand einer PDU (Power Distribution Unit) festzustellen und zur Regelung der Kühleinrichtung zu verwenden.

Wird beispielsweise hierbei festgestellt, dass eine höhere Leistungsaufnahme vorhanden ist, so kann daraus geschlussfolgert werden, dass etwas zeitverzögert auch eine erhöhte Wärmeentwicklung zu erwarten ist. Hierauf kann mit der Kühleinrichtung bereits vorsorglich regiert werden indem der Druck im Warmluftbereich verringert wird, das heißt, dass die Lüfter der Kühleinrichtung mit einer höheren Drehzahl laufen, so dass mehr Luftvolumen pro Einheit gefördert wird und eines bessere Kühlung der Komponenten der Informations- und Kommunikationstechnik ermöglicht wird.

Ein gattungsgemäßes Verfahren ist durch die Erfindung dadurch weitergebildet, dass eine Druckdifferenz zwischen dem Druck in einem Warmluftbereich, welcher an der Rückseite der Komponenten der Informations- und Kommunikationstechnik in dem Geräteschrank ausgebildet ist und winem Abgabebereich der gekühlten Warmluft der Kühleinrichtung an die Umgebung ermittelt wird. Ferner werden die Lüfter der Kühleinrichtung derart betrieben, dass ein festgelegter Druck im Warmluftbereich erreicht wird, wobei der Druck kleiner oder gleich dem Druck in der Umgebung des Geräteschrankes ist.

Durch eine derartige Regelung des Differenzdruckes wird erreicht, dass eine effiziente Kühlung der Komponenten der Informations- und Kommunikationstechnik, welche in dem Geräteschrank vorhanden sind, erreicht wird, ohne unnötige Energie zu verschwenden, wie bereits zuvor in Bezug auf den Geräteschrank beschrieben. Wie erläutert, liegt der Erfindung die Erkenntnis zugrunde, dass zum einen die Regelung über die Druckdifferenz zwischen Druck außerhalb des Geräteschrankes und Druck innerhalb des Geräteschrankes eine schnellere Reaktion ermöglicht als eine Regelung anhand der Temperatur. Zum anderen ist die Erkenntnis, dass gerade bei der Verwendung eines Rücktür-Wärmekühlers es vorteilhaft ist, lediglich die Druckdifferenz zwischen an der Ausblasstelle der Kühleinrichtung und dem Warmluftbereich zu ermitteln. Hierbei muss kein großer Verkabelungsaufwand vorgenommen werden und es kann sogar eine Nachrüstlösung realisiert werden.

Abhängig von den im Geräteschrank verbauten Elementen, ist es wünschenswert, dass der Druck im Warmluftbereich in etwa dem Umgebungsdruck entspricht, das heißt die Druckdifferenz null ist. Sind passive Komponenten oder Komponenten mit schwachen Lüftern im Geräteschrank vorgesehen, so kann es auch vorteilhaft sein, wenn die Druckdifferenz negativ ist, dies bedeutet, dass der statische Druck im Warmluftbereich geringer als außerhalb des Geräteschrankes ist, so dass ein Einsaugen der Kühlluft von der Frontseite des Geräteschrankes unterstützt wird.

Ein weiterer Vorteil der Regelung der Kühleinrichtung anhand des Druckgefälles ist, dass der gewünschte Druck somit unabhängig von der Bestückung des Geräteschrankes immer anliegt. Dies ist insbesondere vorteilhaft, wenn der Geräteschrank des Öfteren umgebaut wird und beispielsweise Blindplatten für die Komponenten vorhanden sind oder vergessen werden. Weiterhin ist erfindungsgemäss vorgesehen, dass der Druck in dem Warmluftbereich abhängig von einer oder mehreren gemessenen Temperaturen geregelt wird, wobei die Temperaturen an einer oder mehreren folgenden Stellen gemessen werden: außerhalb des Geräteschrankes, an der Frontseite des Geräteschrankes, im Warmluftbereich, am Abgabebereich der Kühleinrichtung, vor, hinter, innerhalb der Komponenten der Informations- und Kommunikationstechnik und/oder dass die Leistungsaufnahme aller oder eines Großteils der Komponenten der Informations- und Kommunikationstechnik in dem Geräteschrank ermittelt wird und wobei der Druck im Warmluftbereich anhand der Leistungsaufnahme geregelt wird und/oder dass Daten aus dem Servermanagement, insbesondere CPULeistungen und/oder Rechnerauslastung, Netzwerkauslastungen erhalten werden und der Druck im Warmluftbereich anhand der Daten des Servermanagements geregelt wird.

Wie erwähnt kann der Druck im Warmluftbereich auch zusätzlich abhängig von einer oder mehreren gemessenen Temperaturen geregelt werden, wobei die Temperaturen beispielsweise an einer oder mehrerer der folgenden Stellen gemessen werden können, außerhalb des Geräteschrankes, an der Frontseite des Geräteschrankes, im Warmluftbereich, am Abgabebereich der Kühleinrichtung, vor, hinter, innerhalb der Komponenten der Informations- und Kommunikationstechnik. Durch eine zusätzliche Regelung des Druckes anhand der Temperatur kann erreicht werden, dass auf etwaige Temperaturschwankungen zeitnah reagiert werden kann. Anders ausgedrückt findet nun eine adaptive Druckregelung des Druckes im Warmluftbereich statt. Hierdurch kann auf veränderte Leistung beziehungsweise Umweltkriterien Bezug genommen werden. Beispielsweise in dem Fall, dass das Rechenzentrum in dem der Geräteschrank vorgesehen ist, eine Rechenzentrumskühlung aufweist, diese aber aufgrund der Außentemperatur nicht mehr die gewünschte Leistung aufbringt, so kann über die Änderung der Druckdifferenz, insbesondere über ein weiteres Absenken des statischen Druckes im Warmluftbereich hierauf Rücksicht genommen werden und so eine möglichst gleichbleibende Kühlleistung für die Komponenten der Informations- und Kommunikationstechnik, welche in dem Geräteschrank vorgesehen sind, bereitgestellt werden. Alternativ oderfakultativ hierzu kann auch die Leistungsaufnahme aller oder zumindest eines Großteils der Komponenten der Informations- und Kommunikationstechnik, die in dem Geräteschrank vorhanden sind, ermittelt werden und der Druck im Warmluftbereich anhand dieser Leistungsaufnahme geregelt werden. Die Ermittlung der Leistungsaufnahme kann beispielsweise durch PDUs erfolgen. Hierdurch ist es möglich, bereits eine Vorhersage über die Wärmeentwicklung der Komponenten der Informations- und Kommunikationstechnik zu tätigen und beispielsweise bei einer verringerten Leistungsaufnahme auch weniger Kühlleistung anzubieten, das heißt den Druck im Warmluftbereich tendenziell anzuheben, so dass über die Komponenten der Informations- und Kommunikationstechnik ein geringerer Luftvolumenstrom pro Zeiteinheit vorhanden ist. Dies bedeutet, dass die Lüfter der Kühleinrichtung weniger stark laufen müssen und somit Energie gespart werden kann.

Ebenfalls können Daten aus dem Servermanagement, insbesondere die CPU-Leistung und/oder Rechenleistung, Netzwerkleistung oder dergleichen erhalten werden und der Druck im Warmbereich anhand dieser Daten des Servermanagements variiert werden. Eine derartige Regelung weist ähnliche Vorteile wie eine Regelung in Bezug auf die Leistungsaufnahme auf.

Die Erfindung wird nachfolgend anhand eines Ausführungsbeispiels und anhand einer schematischen Zeichnung erläutert. Hierbei zeigt:

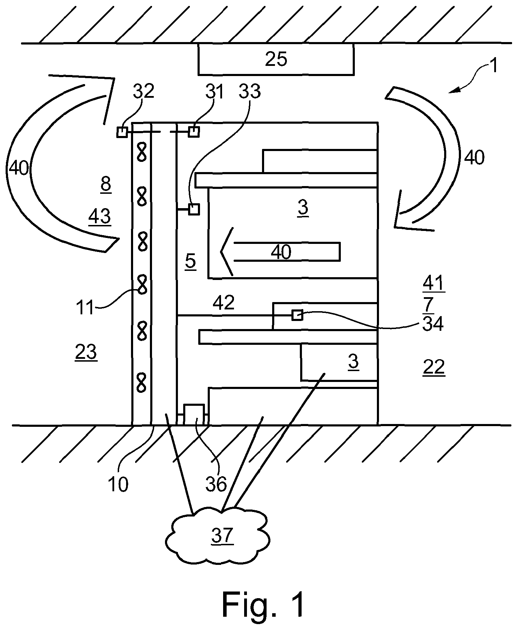

- Fig. 1: eine schematische Ansicht eines erfindungsgemäßen Geräteschrankes in einem Rechenzentrum.

In Fig. 1 ist eine stark vereinfachte geschnittene Ansicht eines erfindungsgemäßen Geräteschranks 1 dargestellt. In dem Geräteschrank 1 sind Komponenten der Informations- und Kommunikationstechnik, welche auch als Equipment bezeichnet werden können, dargestellt. Bei diesen Komponenten kann es sich beispielsweise um Server, Kommunikationsgeräte, Switches, Netzwerkkomponenten, USVs oder andere derartige Komponenten handeln. Im Folgenden werden sie vereinfacht als Server 3 bezeichnet.

An der Rückseite 8 des Geräteschrankes 1 ist eine Kühleinrichtung 10 vorgesehen, welche eine Vielzahl an Lüftern 11 aufweist. Zwischen den Servern 3 und der Kühleinrichtung 10 ist ein Warmluftbereich 5 ausgebildet. Dieser wird weiter unten detaillierter beschrieben.

Die grundsätzliche Betriebsweise eines derartigen Geräteschrankes 1 ist, dass Kühlluft 41 über die Server 3 in den Innenraum des Geräteschrankes 1 strömt. Beim Strömen über die Server 3 werden diese gekühlt beziehungsweise es wird Wärme abgeführt, die Kühlluft 41 wird erwärmt und gelangt so als Warmluft 42 in den Warmluftbereich 5. Aus diesem tritt sie über die Kühleinrichtung 10 auf die Rückseite 8 des Geräteschrankes 1 wiederum aus. Beim Durchtritt durch die Kühleinrichtung 10, welche beispielsweise als Rücktürwärmetauscher ausgeführt sein kann, wird die Warmluft 42 abgekühlt und tritt als gekühlte Warmluft 43 aus. Hierdurch entsteht ein Luftstrom 40, welcher von einer Vorderseite 7 durch den Geräteschrank 1 hindurch auf dessen Rückseite 8 wieder hinaus und oberhalb des Geräteschrankes 1 im Rechenzentrum zurück zur Frontseite 7 geführt ist.

Mittels der Lüfter 11 in der Kühleinrichtung 10 kann die Luft von der Vorderseite 7 des Geräteschrankes 1 über die Server 3 gesaugt werden. Zusätzlich ist es oft auch vorgesehen, dass die Server 3 selbst aktive Lüfter aufweisen und mittels dieser Luft von der Vorderseite 7 einsaugen und aktiv in den Warmluftbereich 5 ausblasen.

Abhängig von diesen Lüftern, insbesondere wie stark diese die Luft in den Warmluftbereich einblasen und wie stark aus dem Warmluftbereich Luft durch die Kühleinrichtung 10 austritt beziehungsweise durch deren Lüfter 11 herausgesogen wird, stellt sich ein bestimmter statischer Druck im Warmluftbereich 5 ein. Idealerweise sollte dieser Druck im Wesentlichen dem Druck vor dem Geräteschrank 1 im Raum 22 entsprechen. Dies hat zur Folge, dass keine ungewollten Luftströmungen über die Server 3 auftreten.

Der statische Druck im Warmluftbereich 5 kann im Wesentlichen über die Lüfter 11 der Kühleinrichtung 10 beeinflusst werden, das heißt, laufen diese schneller, so verringert sich der Druck, laufen sie langsamer erhöht er sich. Grundsätzlich wäre daher eine Messung des Druckes vor dem Geräteschrank 1 im Raum 22 und im Warmluftbereich 5 hilfreich. Da hierfür jedoch ein Kabel beziehungsweise eine Sensorleitung zu der Frontseite 7 des Serverschrankes 1 verlegt werden müsste, führt die zu einem erhöhten Verkabelungsaufwand.

Entsprechend der Erfindung wurde erkannt, da sich die Rückseite 8 mit dem Raum 23 hinter dem Geräteschrank 1 im Wesentlichen in derselben Umgebung wie die Vorderseite 7 des Gerätschrankes 1 mit dem Raum 22 vor dem Geräteschrank 1 befindet, dass in diesen beiden Bereichen im Wesentlichen derselbe statische Druck herrscht. Dies bedeutet, dass es ausreichend ist, den statischen Druck hinter dem Geräteschrank 1 und im Warmluftbereich 5 in dem Geräteschrank zu bestimmen. Hierfür sind entsprechend der Erfindung beispielsweise ein erster Drucksensor 31 im Warmluftbereich 5 und ein zweiter Drucksensor 32 im rückwärtigen Bereich des Geräteschrankes 1 beziehungsweise am rückwärtigen Bereich der Kühleinrichtung 10 vorgesehen.

Wird über diese beiden Sensoren der Druck bestimmt und die Druckdifferenz ermittelt, so kann der Druck im Warmluftbereich 5 derart eingestellt werden, dass er idealerweise entsprechend dem Außendruck ist oder höchstens etwas geringer als dieser ist, so dass sichergestellt wird, dass ein Luftstrom über die Server 3 vorhanden ist und keine ungewollte Rückströmung auftritt.

Befinden sich in dem Raum in dem der Geräteschrank 1 vorhanden ist jedoch Verengungen, beispielsweise durch Einbauten 25, so kann der Zustand auftreten, dass der Luftdruck hinter dem Geräteschrank 1 etwas höher ist als der Luftdruck vor dem Geräteschrank 1. Dies kann beispielsweise durch einen entsprechenden Offset in der Regelung bezüglich des Luftdruckes im Warmluftbereich 5 berücksichtigt sein.

Zusätzlich können auch Temperatursensoren vorgesehen sein, deren Ergebnisse ebenfalls für die Regelung des Drucks im Warmluftbereich 5 herangezogen werden. Exemplarisch sind hierzu ein erster Temperatursensor 33 im Warmluftbereich 3 und ein zweiter Temperatursensor 34 in beziehungsweise an den Servern 3 vorgesehen. Erhöht sich beispielsweise die Temperatur, welche durch einen oder beide der Sensoren 33, 34 gemessen wird, so kann daraus geschlossen werden, dass eine bessere Kühlung notwendig ist. Infolgedessen wird der Druck im Warmluftbereich 5 durch eine höhere Lüftungsdrehungsdrehzahl der Lüfter 11 abgesenkt, so dass mehr kühle Luft 41 von der Vorderseite 7 des Geräteschrankes 1 durch beziehungsweise über die Server 3 fließt.

Andere Indikatoren für die Druckregelung können beispielsweise die momentane Leistungsaufnahme der Server 3 sein, welche beispielsweise über eine PDU (Power Distribution Unit) ermittelt werden kann und der Kühleinrichtung 10 zur Verfügung gestellt werden kann. In ähnlicher Weise können Daten über die aktuelle Leistung auch von einem Servermanagement 37 zur Verfügung gestellt werden.

Mit dem erfindungsgemäßen Geräteschrank und dem erfindungsgemäßen Verfahren zum Regeln einer Kühleinrichtung ist es somit möglich, eine effektive Kühlung der im Geräteschrank vorhandenen Komponenten zu ermöglichen.

## Patentansprüche

1. Geräteschrank (1), in dem Komponenten der Informations- und Kommunikationstechnik (3) aufgenommen sind, welche im Betrieb Abwärme erzeugen,
mit einer Front- (7) und einer Rückseite (8),
wobei der Geräteschrank (1) und/oder die Komponenten der Informations- und Kommunikationstechnik (3) ausgebildet sind, Kühlluft (41) von der Frontseite (7) zum Kühlen zu nutzen und als erwärmte Abluft, welche weiter als Warmluft (42) bezeichnet wird, abzugeben,
wobei zum Kühlen der Warmluft (42) eine Kühleinrichtung (10) vorgesehen ist, welche die Warmluft (42) kühlt und an eine Umgebung des Geräteschrankes (1) abgibt, und
wobei die Kühleinrichtung (10) Lüfter (11) zum Ansaugen der Warmluft (42) und zum Ausblasen der gekühlten Warmluft (43) aufweist,
wobei an der Rückseite (8) der Komponenten der Informations- und Kommunikationstechnik (3) in dem Geräteschrank (1) ein Warmluftbereich (5) mit Warmluft (41) ausgebildet ist,
wobei Sensoren (31, 32) zum Ermitteln des relativen Unterdruckes, welcher einer Druckdifferenz zwischen einem Druck im Warmluftbereich (5) und einem Druck im Abgabebereich der gekühlten Warmluft (43) der Kühleinrichtung (10) an die Umgebung ist, vorhanden sind, und
wobei die Sensoren (31, 32) zum Ermitteln des relativen Unterdruckes zum Ermitteln der Druckdifferenz zwischen dem Warmluftbereich (5) und dem Abgabebereich der gekühlten Warmluft (43) der Kühleinrichtung (10) an die Umgebung vorgesehen sind und jeweils dort angeordnet sind
,wobei der Geräteschrank (1) und/oder die Komponenten der Informations- und Kommunikationstechnik (3) ausgebildet sind die erwärmte Abluft in Richtung der Rückseite (8) abzugeben,
und die Kühleinrichtung (10) ausgebildet und eingerichtet ist, mittels der Lüfter (11) einen festgelegten Druck im Warmluftbereich (5) aufrechtzuerhalten, wobei der Druck kleiner oder gleich dem Druck in der Umgebung des Geräteschrankes (1) ist, **gekennzeichnet dadurch**
- **dass** mindestens ein Temperatursensor (34, 35) an mindestens einer der folgenden Stellen vorgesehen sind: außerhalb des Geräteschrankes (1), an der Frontseite (7) des Geräteschrankes (1), im Warmluftbereich (5), am Abgabebereich der Kühleinrichtung (10), vor, hinter, innerhalb der Komponenten der Informations- und Kommunikations-technik (3), wobei die Kühleinrichtung (10) ausgebildet und eingerichtet ist, anhand der durch den mindestens einen Temperatursensor (34, 35) festgestellten Temperatur, den Druck im Warmluftbereich (5) zu regeln, und/oder
- **dass** die Kühleinrichtung (10) ausgebildet und eingerichtet ist, anhand der momentanen Leistungsaufnahme der Komponenten der Informations- und Kommunikationstechnik (3) den Druck im Warmluftbereich (5) zu regeln und/oder
- **dass** die Kühleinrichtung (10) ausgebildet und eingerichtet ist, anhand von Daten aus dem Servermanagement (37), insbesondere CPU-Leistungen, Rechnerauslastung und/oder Netzwerkauslastungen, den Druck im Warmluftbereich (5) zu regeln.

2. Geräteschrank nach Anspruch 1,
**dadurch gekennzeichnet,**
**dass** die Kühleinrichtung (10) als Rücktür-Kühleinrichtung ausgeführt ist, welche an der Rücktür des Geräteschrankes (1) oder an Stelle der Rücktür des Geräteschrankes (1) vorgesehen ist.

3. Geräteschrank nach einem der Ansprüche 1 oder 2,
**dadurch gekennzeichnet,**
**dass** mindestens ein Sensor (31, 32) zum Ermitteln des Druckes im Warmluftbereich (5) im oder am Rahmen des Geräteschrankes (1), insbesondere in einer Nut, vorgesehen ist.

4. Verfahren zum Betreiben einer Kühleinrichtung (10), insbesondere der Lüfter (11) einer Kühleinrichtung (10), für einen Geräteschrank (1) in dem Komponenten der Informations- und Kommunikationstechnik (3) aufgenommen sind, welche im Betrieb Abwärme erzeugen,
wobei der Geräteschrank (1) eine Front- (7) und eine Rückseite (8) aufweist, wobei der Geräteschrank (1) und/oder die Komponenten der Informations- und Kommunikationstechnik (3) ausgebildet sind, Kühlluft (41) von der Frontseite (7) zum Kühlen zu nutzen und als erwärmte Abluft, welche weiter als Warmluft (42) bezeichnet wird, abzugeben,
wobei zum Kühlen der Warmluft (42) die Kühleinrichtung (10) vorgesehen ist, welche die Warmluft (42) kühlt und an eine Umgebung des Geräteschrankes (1) ausgibt, und
wobei die Kühleinrichtung (10) Lüfter (11) zum Ansaugen der Warmluft (42) und zum Ausblasen der gekühlten Warmluft (43) aufweist,
wobei ein Warmluftbereich (5) an der Rückseite der Komponenten der Informations- und Kommunikationstechnik (3) in dem Geräteschrank (1) ausgebildet ist, wobei der Geräteschrank (1) und/oder die Komponenten der Informations- und Kommunikationstechnik (3) die erwärmte Abluft in Richtung der Rückseite abgeben,
wobei relativeer Unterdruck als eine Druckdifferenz zwischen dem Druck in dem Warmluftbereich (5) und Druck im dem Abgabebereich der gekühlten Warmluft (43) der Kühleinrichtung (10) an die Umgebung ermittelt wird,
und die Lüfter (11) derart betrieben werden, dass ein festgelegter Druck im Warmluftbereich (5) erreicht wird, wobei der Druck kleiner oder gleich dem Druck in der Umgebung des Geräteschrankes (1) ist, **gekennzeichnet dadurch**
- **dass** der Druck in dem Warmluftbereich (5) abhängig von einer oder mehreren gemessenen Temperaturen geregelt wird, wobei die Temperaturen an einer oder mehreren folgenden Stellen gemessen werden: außerhalb des Geräteschrankes (1), an der Frontseite (7) des Geräte-schrankes (1), im Warmluftbereich (5), am Abgabebereich der Kühleinrichtung (10), vor, hinter, innerhalb der Komponenten der Informations- und Kommunikationstechnik (3) und/oder
- **dass** die Leistungsaufnahme aller oder eines Großteils der Komponenten der Informations- und Kommunikationstechnik (3) in dem Geräteschrank (1) ermittelt wird und wobei der Druck im Warmluftbereich (5) anhand der Leistungsaufnahme geregelt wird und/oder
- **dass** Daten aus dem Servermanagement (37), insbesondere CPU-Leistungen und/oder Rechnerauslastung, Netzwerkauslastungen erhalten werden und der Druck im Warmluftbereich (5) anhand der Daten des Servermanagements (37) geregelt wird.

## Claims

1. Equipment cabinet (1), in which IT and communication-technology components (3) are received, which generate waste heat during operation,
comprising a front side (7) and a rear side (8),
wherein the equipment cabinet (1) and/or the IT and communication-technology components (3) are designed to use cooling air (41) from the front side (7) for cooling and to discharge as heated exhaust air, which is also referred to as hot air (42),
wherein in order to cool the hot air (42), a cooling device (10) is provided which cools the hot air (42) and discharges it into the surroundings of the equipment cabinet (1), and
wherein the cooling device (10) comprises fans (11) for drawing in the hot air (42) and blowing out the cooled hot air (43),
wherein a hot-air region (5) containing hot air (41) is formed on the rear side (8) of the IT and communication-technology components (3) in the equipment cabinet (1),
wherein sensors (31, 32) are present for determining the relative negative pressure which corresponds to a pressure differential between a pressure in the hot-air region (5) and a pressure in the discharge region for the cooled hot-air (43) of the cooling device (10) to the surroundings, and
wherein the sensors (31, 32) for determining the relative negative pressure for determining the pressure differential between the hot-air region (5) and the discharge region for the cooled hot-air (43) of the cooling device (10) to the surroundings are provided and are each arranged there,
wherein
the equipment cabinet (1) and/or the IT and communication-technology components (3) are designed to discharge the heated exhaust air towards the rear side (8),
and the cooling device (10) is designed and configured to maintain a specified pressure in the hot-air region (5) by means of the fans (11), wherein the pressure is less than or equal to the pressure in the surroundings of the equipment cabinet (1),
**characterized**
- **in that** at least one temperature sensor (34, 35) is provided at at least one of the following positions: outside the equipment cabinet (1), on the front side (7) of the equipment cabinet (1), in the hot-air region (5), at the discharge region of the cooling device (10), in front of, behind or within the IT and communication-technology components (3), wherein the cooling device (10) is designed and configured to regulate the pressure in the hot-air region (5) on the basis of the temperature detected by the at least one temperature sensor (34, 35), and/or
- **in that** the cooling device (10) is designed and configured to regulate the pressure in the hot-air region (5) on the basis of the current power consumption of the IT and communication-technology components (3), and/or
- **in that** the cooling device (10) is designed and configured to regulate the pressure in the hot-air region (5) on the basis of data from the server management (37), in particular CPU power, computer utilization and/or network utilization.

2. Equipment cabinet according to claim 1,
**characterized in that**
the cooling device (10) is constructed as a rear-door cooling device, which is provided on the rear door of the equipment cabinet (1) or in place of the rear door of the equipment cabinet (1).

3. Equipment cabinet according to any of claims 1 to 2,
**characterized in that**
at least one sensor (31, 32) for determining the pressure in the hot-air region (5) is provided in or on the frame of the equipment cabinet (1), in particular in a groove.

4. Method for operating a cooling device (10), in particular the fans (11) of a cooling device (10), for an equipment cabinet (1) in which IT and communication-technology components (3) are received, which generate waste heat during operation,
wherein the equipment cabinet (1) comprises a front side (7) and a rear side (8), wherein the equipment cabinet (1) and/or the IT and communication-technology components (3) are designed to use cooling air (41) from the front side (7) for cooling and to discharge as heated exhaust air, which is also referred to as hot air (42),
wherein for cooling the hot air (42), the cooling device (10) is provided, which cools the hot air (42) and discharges it into a surroundings of the equipment cabinet (1), and
wherein the cooling device (10) comprises fans (11) for drawing in the hot air (42) and blowing out the cooled hot air (43),
wherein a hot-air region (5) is formed at the rear side of the IT and communication-technology components (3) in the equipment cabinet (1),
wherein the equipment cabinet (1) and/or the IT and communication-technology components (3) discharge the heated exhaust air towards the rear side,
wherein
a relative negative pressure is determined as a pressure differential between the pressure in the hot-air region (5) and pressure in the discharge region for the cooled hot air (43) of the cooling device (10) to the surroundings, and
the fans (11) are operated such that a specified pressure is reached in the hot-air region (5), wherein the pressure is less than or equal to the pressure in the surroundings of the equipment cabinet (1),
**characterized**
- **in that** the pressure in the hot-air region (5) is regulated depending on one or more measured temperatures, wherein the temperatures are measured at one or more of the following positions: outside the equipment cabinet (1), on the front side (7) of the equipment cabinet (1), in the hot-air region (5), at the discharge region of the cooling device (10), in front of, behind or within the IT and communication-technology components (3), and/or
- **in that** the power consumption of all or a majority of the IT and communication-technology components (3) in the equipment cabinet (1) is determined, and wherein the pressure in the hot-air region (5) is regulated on the basis of the power consumption, and/or
- **in that** data are obtained from the server management (37), in particular CPU power and/or computer utilization, or network utilization, and the pressure in the hot-air region (5) is regulated on the basis of the data from the server management (37).

## Revendications

1. Armoire électrique (1) dans laquelle des composants du système d'information et de communication (3) qui génèrent de la chaleur en mode de fonctionnement sont logés, avec une face avant (7) et une face arrière (8),
l'armoire électrique (1) et/ou les composants du système d'information et de communication (3) étant conçus pour utiliser l'air de refroidissement (41) de la face avant (7) pour le refroidissement et pour l'évacuer sous forme d'air d'évacuation, lequel est appelé air chaud (42) plus loin,
dans laquelle, pour le refroidissement de l'air chaud (42), il est prévu un dispositif de refroidissement (10) qui refroidit l'air chaud (42) et l'évacue dans un environnement de l'armoire électrique (1), et
dans laquelle le dispositif de refroidissement (10) possède des ventilateurs (11) pour aspirer l'air chaud (42) et pour refouler l'air chaud refroidi (43),
une zone d'air chaud (5) étant formée avec de l'air chaud (41) sur la face arrière (8) des composants du système d'information et de communication (3) dans l'armoire électrique (1),
des capteurs (31, 32) étant présents pour déterminer la dépression relative, laquelle est une différence de pression entre une pression dans la zone d'air chaud (5) et une pression dans la zone d'évacuation de l'air chaud refroidi (43) du dispositif de refroidissement (10) dans l'environnement, et
les capteurs (31, 32) pour déterminer la dépression relative pour déterminer la différence de pression entre la zone d'ait chaud (5) et la zone d'évacuation de l'air chaud refroidi (43) du dispositif de refroidissement (10) dans l'environnement étant prévus et disposés à ces emplacements,
l'armoire électrique (1) et/ou les composants du système d'information et de communication (3) étant conçus pour évacuer l'air d'évacuation réchauffé en direction de la face arrière (8), et
le dispositif de refroidissement (10) étant conçu et équipé pour maintenir au moyen des ventilateurs (11) une pression définie dans la zone d'air chaud (5), la pression étant inférieure ou égale à la pression dans l'environnement de l'armoire électrique (1),
**caractérisée**
- **en ce qu'**au moins un capteur de température (34, 35) est prévu à au moins un des emplacements suivants : à l'extérieur de l'armoire électrique (1), sur la face avant (7) de l'armoire électrique (1), dans la zone d'air chaud (5), au niveau de la zone d'évacuation du dispositif de refroidissement (10), devant, derrière, à l'intérieur des composants du système d'information et de communication (3), le dispositif de refroidissement (10) étant conçu et équipé pour réguler la pression dans la zone d'air chaud (5) sur la base de la température déterminée par l'au moins un capteur de température (34, 35), et/ou
- que le dispositif de refroidissement (10) étant conçu et équipé pour réguler la pression dans la zone d'air chaud (5) sur la base de la puissance consommée instantanée des composants du système d'information et de communication (3), et/ou
- que le dispositif de refroidissement (10) étant conçu et équipé pour réguler la pression dans la zone d'air chaud (5) sur la base des données de la gestion de serveur (37), en particulier des puissances de CPU, de la charge d'ordinateur et/ou des charges de réseau.

2. Armoire électrique selon la revendication 1,
**caractérisée**
**en ce que** le dispositif de refroidissement (10) est conçu comme un dispositif de refroidissement de porte arrière qui est prévu sur la porte arrière de l'armoire électrique (1) ou à l'emplacement de la porte arrière de l'armoire électrique (1).

3. Armoire électrique selon la revendication 1 ou 2,
**caractérisée**
**en ce qu'**au moins un capteur (31, 32) est prévu pour déterminer la pression dans la zone d'air chaud (5) dans ou sur le châssis de l'armoire électrique (1), en particulier dans une rainure.

4. Procédé d'exploitation d'un dispositif de refroidissement (10), en particulier des ventilateurs (11) d'un dispositif de refroidissement (10), pour une armoire électrique (1) dans laquelle des composants du système d'information et de communication (3) qui génèrent de la chaleur en mode de fonctionnement sont logés,
l'armoire électrique (1) possédant une face avant (7) et une face arrière (8),
l'armoire électrique (1) et/ou les composants du système d'information et de communication (3) étant conçus pour utiliser l'air de refroidissement (41) de la face avant (7) pour le refroidissement et pour l'évacuer sous forme d'air d'évacuation, lequel est appelé air chaud (42) plus loin,
le dispositif de refroidissement (10) qui refroidit l'air chaud (42) et l'évacue dans un environnement de l'armoire électrique (1) étant prévu pour le refroidissement de l'air chaud (42), et
le dispositif de refroidissement (10) possédant des ventilateurs (11) pour aspirer l'air chaud (42) et pour refouler l'air chaud refroidi (43),
une zone d'air chaud (5) étant formée sur la face arrière des composants du système d'information et de communication (3) dans l'armoire électrique (1),
l'armoire électrique (1) et/ou les composants du système d'information et de communication (3) évacuant l'air d'évacuation réchauffé en direction de la face arrière, une dépression relative étant déterminée comme une différence de pression entre la pression dans la zone d'air chaud (5) et la pression dans la zone d'évacuation de l'air chaud refroidi (43) du dispositif de refroidissement (10) dans l'environnement, et
les ventilateurs (11) étant actionnés de telle sorte qu'une pression définie est atteinte dans la zone d'air chaud (5), la pression étant inférieure ou égale à la pression dans l'environnement de l'armoire électrique (1), **caractérisé**
- **en ce que** la pression dans la zone d'ait chaud (5) et régulée en fonction d'une ou plusieurs températures mesurées, les températures étant mesurées sur un ou plusieurs des emplacements suivants : à l'extérieur de l'armoire électrique (1), sur la face avant (7) de l'armoire électrique (1), dans la zone d'air chaud (5), au niveau de la zone d'évacuation du dispositif de refroidissement (10), devant, derrière, à l'intérieur des composants du système d'information et de communication (3), et/ou
- que la puissance consommée de tous ou d'une grande partie des composants du système d'information et de communication (3) dans l'armoire électrique (1) déterminée et la pression dans la zone la zone d'air chaud (5) est régulée sur la base de la puissance consommée et/ou
- que les données de la gestion de serveur (37), en particulier les puissances de CPU, la charge d'ordinateur et/ou les charges de réseau sont recueillies et la pression dans la zone d'air chaud (5) est régulée sur la base des données de la gestion de serveur (37).
